# EUROPEAN PATENT APPLICATION

(11) **EP 2 835 833 A2**
(43) Date of publication of application: **11.02.2015**
(21) Application number: 14179908.0
(22) Date of filing: 05.08.2014
(51) Int. Cl.: H01L 29/78, H01L 21/336, H01L 29/20, H01L 29/423, H01L 29/08, H01L 29/207, H01L 29/45, H01L 29/49, H01L 29/06, H01L 23/373

(54) **Nitride-based field-effect transistor and method of fabricating the same**

(30) Priority: 05.08.2013 KR 20130092378
(71) Applicant: Seoul Semiconductor Co., Ltd., Ansan-si, Gyeonggi-do 425-851 (KR)
(72) Inventor: Takeya, Motonobu, Ansan-si, Gyeonggi-do 425-851 (KR)
(74) Representative: Stolmár & Partner

(57) **Abstract**

Disclosed herein is a GaN-based transistor including source electrodes (72), first switch semiconductor layers (40) of a first conductivity type formed under the respective source electrodes, second switch semiconductor layers (50) of a second conductivity type formed under the respective first switch semiconductor layers, third switch semiconductor layers (60) of the first conductivity type configured to surround lower parts of the second switch semiconductor layers and sides of the first switch semiconductor layers and the second switch semiconductor layers, gates (75, 76) each having vertical faces or inclined faces in which a channel is formed on sides of the first switch semiconductor layer and the second switch semiconductor layer, gate insulating layers (74) formed under the gates, and a drain electrode (20) electrically coupled to the source electrodes along a flow of charges in a vertical direction that passes through the channels.

## Description

### BACKGROUND

Exemplary embodiments of the present invention relate to a nitride-based transistor device having a high voltage resistant property and a high current density, and more particularly, to a nitride-based vertical type Field Effect Transistor (FET) (heterojunction FET (HFED)) device having a normally off characteristic based on Epitaxial Lateral Overgrowth (ELO).

A power device using a silicon semiconductor in a power AMP circuit, a power circuit, or a motor driving circuit is being used. However, the high voltage-resistant property, low resistance, and high speed of a silicon device have reached the limit due to the limit of a silicon semiconductor, which makes it difficult to meet a market need. Accordingly, the development of a III-V-based device having characteristics, such as a high voltage-resistant property, a high temperature operation, a high current density, high-speed switching, and low on resistance, is being discussed.

The proposed III-V-based device has a horizontal type structure in which sources, gates, and drains are arranged on a surface of a substrate, which is not suitable for power devices that require a high current. Furthermore, there is a problem in that it is not easy to realize a normally off operation essential for power devices. Furthermore, there is a problem in that a so-called current collapse phenomenon in which a drain current reduces is generated because electrons are captured between a semiconductor and a protection layer in a high voltage operation. Furthermore, the III-V-based device having such a horizontal type structure, in particular, a GaN device, is used for a high-speed response of 600 V or lower because it has a low voltage-resistant property.

A Current Aperture Vertical Electron Transistor (CAVET), that is, an FET having a high voltage-resistant property and a high current density, is a vertical type FET grown on a GaN substrate. The CAVET may improve performance using 2DEG and a Current Blocking Layer (CBL) in the gate part. However, the CAVET is limited in its practical use because it is a normally on device.

Furthermore, in fabricating a GaN-based transistor, there is a disadvantage, such as a high price, if the GaN substrate is used, and there is a disadvantage, such as a low Breakdown Voltage (BV), because many Threading Dislocations (TDs) are generated if a sapphire substrate is used.

### SUMMARY

An embodiment of the present invention relates to a vertical type GaN-based FET having a high voltage-resistant property, a high current density, and a normally off characteristic.

An embodiment of the present invention relates to a GaN-based FET of a normally off characteristic, which is capable of fabricated at low cost.

In one embodiment, a GaN-based transistor includes source electrodes, first switch semiconductor layers of a first conductivity type formed under the respective source electrodes, second switch semiconductor layers of a second conductivity type formed under the respective first switch semiconductor layers, third switch semiconductor layers of the first conductivity type configured to surround lower parts of the second switch semiconductor layers and sides of the first switch semiconductor layers and the second switch semiconductor layers, gates each having vertical faces or inclined faces in which a channel is formed on sides of the first switch semiconductor layer and the second switch semiconductor layer, gate insulating layers formed under the gates, and a drain electrode electrically coupled to the source electrodes along a flow of charges in a vertical direction that passes through the channels.

A depletion layer may be formed in regions of the third switch semiconductor layers configured to surround the sides of the first switch semiconductor layers and the second switch semiconductor layers by the second switch semiconductor layers in the state in which voltage is not applied to the gate.

The GaN-based transistor may further include an additional switch semiconductor layer made of GaN doped with carbon or iron and disposed between each of the second switch semiconductor layers and each of the third switch semiconductor layers.

The edge of part of the second switch semiconductor layer may be configured to reach the boundary of the third switch semiconductor layer.

The first switch semiconductor layer may be configured to have a seen layer capable of performing ELO on the second switch semiconductor layer.

An intrinsic GaN semiconductor layer and the drain electrode may be disposed under the third transistor, and the drain electrode may be attached on top of a thermal conductive substrate.

In another embodiment, a method of fabricating a GaN-based transistor may include forming a GaN semiconductor layer of a first conductivity type over a sapphire substrate, forming switch semiconductor layers by etching the GaN semiconductor layer of the first conductivity type, forming a GaN semiconductor layer of a second conductivity type by performing ELO using the GaN semiconductor layer of the first conductivity type as a seed layer, etching regions which belong to the GaN semiconductor layer of the second conductivity type and the GaN semiconductor layer of the first conductivity type and in which gate electrodes are to be formed, forming an intrinsic GaN semiconductor layer over the etched surfaces, forming a high-concentration GaN semiconductor layer over the intrinsic GaN semiconductor layer, extending etched spaces not filled with the intrinsic GaN semiconductor layer when forming the intrinsic GaN semiconductor layer over the etched surfaces, forming a drain electrode over the high-concentration GaN semiconductor layer, attaching a thermal conductive substrate to the drain electrode, removing the sapphire substrate, forming an insulating layer on a surface from which the sapphire substrate has been removed, forming gate electrodes over the insulating layer, etching regions of the insulating layer in which source electrodes are to be formed, and forming the source electrodes.

A lift-off process may be used to remove the sapphire substrate. The method may further include performing etching for removing surfaces damaged by the lift-off process before forming the insulating layer on the surface from which the sapphire substrate has been removed after removing the sapphire substrate.

The method may further include forming a guard ring or performing annealing before forming the insulating layer on the surface from which the sapphire substrate has been removed after removing the sapphire substrate.

Extending the remaining etched spaces may include performing etching using a method of infiltrating an etchant into the spaces not filled with the intrinsic GaN semiconductor.

Attaching the thermal conductive substrate on top of the drain electrode may include forming a medium layer over the drain electrodes and attaching the thermal conductive substrate on top of the medium layer.

### BRIEF DESCRIPTION OF THE DRAWINGS

The above and other aspects, features and other advantages will be more clearly understood from the following detailed description taken in conjunction with the accompanying drawings, in which:
FIG. 1 is a cross-sectional view illustrating the structure of a GaN-based FET according to an embodiment of the present invention;
FIG. 2 is a cross-sectional view illustrating the normally off characteristic of the GaN-based FET of FIG. 1;
FIG. 3 is a cross-sectional view illustrating a GaN-based FET capable of slightly increasing a threshold voltage Vth in accordance with another embodiment of the present invention;
FIG. 4 is a cross-sectional view illustrating a GaN-based FET capable of reducing the leakage current in accordance with another embodiment of the present invention; and
FIGS. 5 to 19B are process diagrams illustrating a process of fabricating the GaN-based FET of FIG. 1.

### DESCRIPTION OF SPECIFIC EMBODIMENTS

Hereinafter, embodiments of the present invention are described in detail with reference to the accompanying drawings. The following embodiments are provided as examples in order for those skilled in the art to which the present invention pertains to be able to readily understand the spirit of the present invention. Accordingly, the present invention is not limited to the following embodiments, but may be embodied in different forms. Furthermore, in the drawings, the width, length, thickness, etc. of each element may have been enlarged for convenience. Furthermore, when it is described that one element is disposed "over" or "on" the other element, one element may be disposed "right over" or "right on" the other element or a third element may be disposed between the two elements. The same reference numbers are used throughout the specification to refer to the same or like parts.

In descriptions of the following embodiments, an expression "GaN-based semiconductor" is not specially limited to GaN, and may be various nitride-based semiconductors, for example, a ternary system, such as AlGaN or InGaN, and a quanternary system, such as AlInGaN.

Furthermore, an "n type" is described as being a "first conductivity type" and a "p type" is described as being a "second conductivity type", and vice versa.

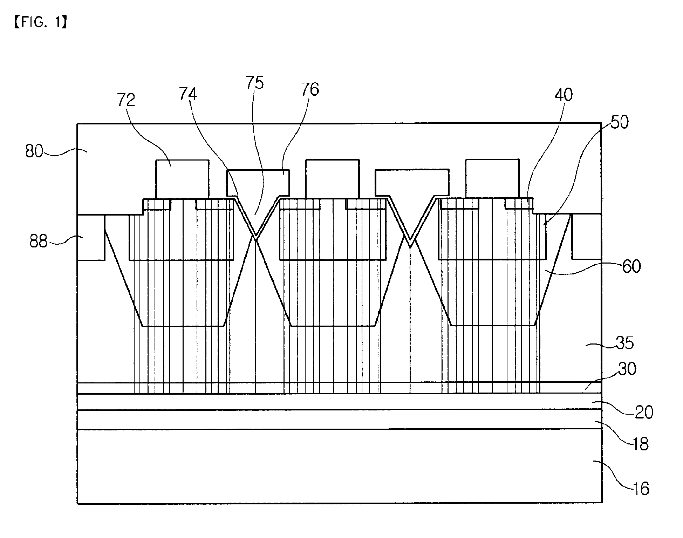

FIG. 1 is a cross-sectional view illustrating the structure of a GaN-based FET according to an embodiment of the present invention. Numerical values disclosed in the drawings and descriptions are only illustrative, and the present invention is not limited thereto.

The illustrated GaN-based FET may include a drain electrode layer 20, a high-concentration n type GaN semiconductor layer 30 placed on the drain electrode layer 20, an intrinsic GaN semiconductor layer 35 placed on the high-concentration n type GaN semiconductor layer 30, first to third switch semiconductor layers 40, 50, and 60 formed over the intrinsic GaN semiconductor layer 35 and configured to fill trenches, gate cores 75 each disposed between the two third switch semiconductor layers 60 and configured in a V shape, gate insulating layers 74 each disposed under the gate core 75, gate electrodes 76 each placed on the gate core 75, and source electrodes 72 each disposed between the two gate electrodes 76 and on the first switch semiconductor layer 40.

The drain electrode layer 20 has been illustrated as being formed on the lower side in order to facilitate the dissipation of heat in the vertical type FET structure. In other implementations for reducing the thickness of the device, however, the drain electrode layer 20 may be formed on the side of the high-concentration n type GaN semiconductor layer or on the side in such a way as to be connected to a separate conductive layer that comes in contact with the high-concentration n type GaN semiconductor layer.

In order to facilitate the dissipation of heat, the drain electrode layer 20 may be made of metal, including one or more of Ti, Al, and Au, but may be made of a conductive semiconductor or organic substance if the dissipation of heat is not important.

The high-concentration n type GaN semiconductor layer 30 may function as a buffer layer or a blocking layer, and may be formed in such a manner that high-concentration n type-doped GaN is deposited. The high-concentration n type GaN semiconductor layer 30 may have a thickness of about 0.1 *µ*m ∼ 0.5 *µ*m, for example, about 0.3 *µ*m.

The intrinsic GaN semiconductor layer 35 may be made of intrinsic GaN that is grown in an ELO manner, and may have a thickness of about 7.0 *µ*m ∼ 20.0 *µ*m, for example, about 11.0 *µ*m. The intrinsic GaN semiconductor layer 35 may have a thickness of about 5.0 *µ*m ∼ 12.0 *µ*m, for example, about 8.0 *µ*m in the thickness up to the boundary surface of the second switch semiconductor layer 50 and the third switch semiconductor layer 60 by considering that most of the upper region of the boundary surface is removed and most of the lower region of the boundary surface remains intact.

The first to the third switch semiconductor layers 40, 50, and 60 have a shape in which the intrinsic (u type) or n-type third switch semiconductor layer 60, the p type second switch semiconductor layer 50, and the n+type first switch semiconductor layer 40 are upward stacked. In this case, the first switch semiconductor layer 40 and the second switch semiconductor layer 50 have the same lateral boundary. In contrast, the third switch semiconductor layer 60 is configured to surround the first switch semiconductor layer 40 and the second switch semiconductor layer 50, and configured to have a shape similar to a pot whose width is downward widened and then narrowed. The reason for this is that a depletion layer is formed because the carriers of the second switch semiconductor layer 50 are diffused into the third semiconductor layer 60 configured to surround the second switch semiconductor layer 50 when voltage is not applied to the gate electrode 76.

The FET of the present embodiment may be fabricated by N-face growth and stacking in reverse order of that illustrated in FIG. 1 using a lift-off process. In such a case, the first switch semiconductor layer 40 may be used as a seed layer when the second switch semiconductor layers 50 are formed using an ELO process. If the FET is formed using such a process, the two or more first switch semiconductor layers 40 placed under the single source electrode 72 are physically separated from each other. The separated space is configured to fill the second switch semiconductor layer 50.

The gate core 75 has been illustrated being formed on the side of the first switch semiconductor layer 40 and the second switch semiconductor layer 50 in a wedge shape (i.e., a V shape) that has inclined faces so that a channel according to an n-p-n junction is formed by the first to the third switch semiconductor layers 40, 50, and 60 when a turn-on voltage is applied to the gate electrode 76. In another implementation, the gate core 75 may be formed in a vertical shape. The gate core 75 having such a wedge shape (i.e., a V shape) is advantageous in that the formation of a turn-off depletion layer and a turn-on channel can be easily controlled. The gate core having a vertical shape is advantageous in that it can be easily fabricated.

The source electrode 72 and the gate electrode 76 are alternately formed, and may be made of conductive materials, such as metal or a conductive layer. In some implementations, a protection layer 80 configured to protect the source electrodes 72 and the gate electrodes 75 and to support connection and insulation with externally drawn lines may be formed on top of the GaN-based FET. For example, the protection layer 80 may be made of AlN or SiN.

A thermal conductive substrate 16 configured to dissipate heat and provide mechanical support and a medium layer 18 configured to mediate the stack structure of the drain electrode 20 and the thermal conductive substrate 16 may be formed under the drain electrode 20.

The medium layer 18 may be made of novel metal having a high process affinity and thermal/electrical conductivity. For example, the medium layer 18 may be made of nano Ag, AuSn, NiSn, Au, Ag, or Al.

The thermal conductive substrate 16 may be formed of a copper substrate having excellent thermal conductivity and mechanical characteristics.

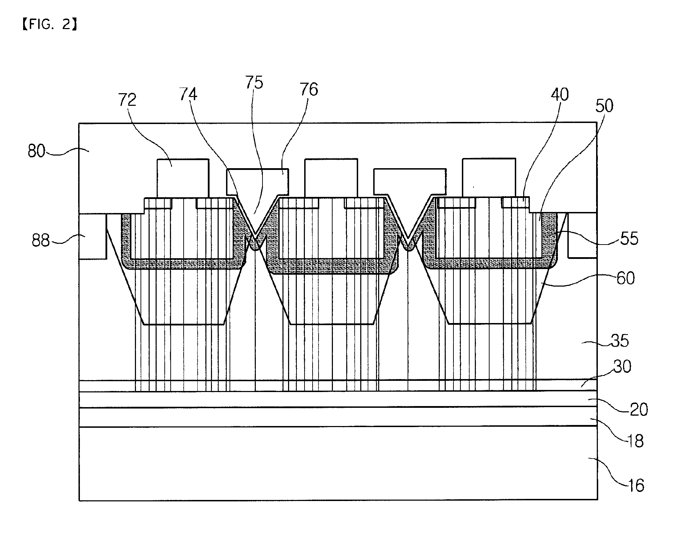

FIG. 2 illustrates a normally off characteristic in which the GaN-based FET of FIG. 1 maintains an off state when any potential is not applied to the gate electrode 76 of the GaN-based FET.

When a potential is not applied to the gate electrode 76, the charge carriers of the second switch semiconductor layers 50 are diffused into the third switch semiconductor layers 60 configured to surround the second switch semiconductor layers 50, and thus a carrier depletion layer DR of a specific thickness is formed in the boundary regions of the second switch semiconductor layers 50 and the third switch semiconductor layers 60. The depletion layer DR blocks current that downward flows along the boundaries of the gate cores 75. As a result, the GaN-based FET has the off state in which current between the source electrode 72 and the drain electrode 20 is blocked.

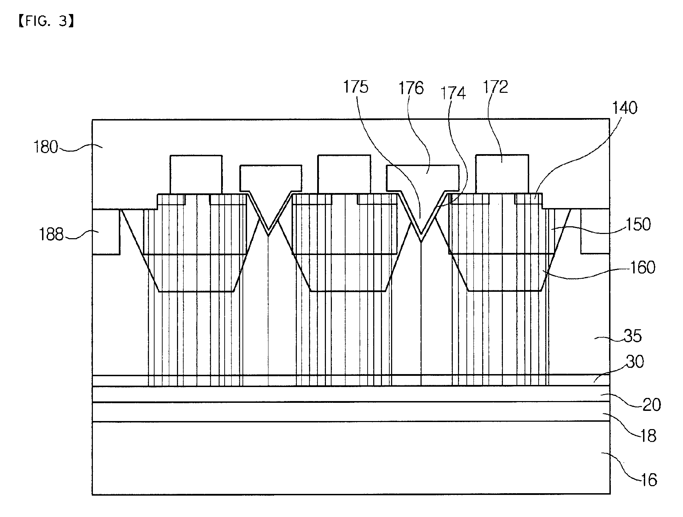

FIG. 3 illustrates a GaN-based FET capable of slightly increasing a threshold voltage Vth in accordance with another embodiment of the present invention.

Most of the elements of the illustrated GaN-based FET are similar to those illustrated in FIG. 1, but the GaN-based FET of FIG. 3 differs from that of FIG. 1 in the structures of a first switch semiconductor layer 140, a second switch semiconductor layer 150, a third switch semiconductor layer 160, and a gate core 175.

It may be seen that the thickness of the second switch semiconductor layer 150 is increased compared to the case of FIG. 1 and thus some edges (i.e., the edges of lower corner parts in FIG. 3) of the second switch semiconductor layer 150 have been illustrated as reaching the boundary of the third switch semiconductor layer 160. Furthermore, the gate core 175 is formed to be downward deeper compared to the case of FIG. 1 so that a forward pn junction potential can be sufficiently applied to the second switch semiconductor layer 150 that has become thick.

If the second switch semiconductor layer 150 becomes thicker compared to the case of FIG. 1 as described above, the FET of FIG. 3 has a stronger normally-off characteristic and/or a higher threshold voltage Vth.

If a forward pn junction potential is applied between the gate electrode and the source electrode, charge carriers move to the sidewall boundary surfaces of the second switch semiconductor layer 150 and the third switch semiconductor layer 160 due to the deeply formed gate core 175, thereby securing a passage for the flow of charges.

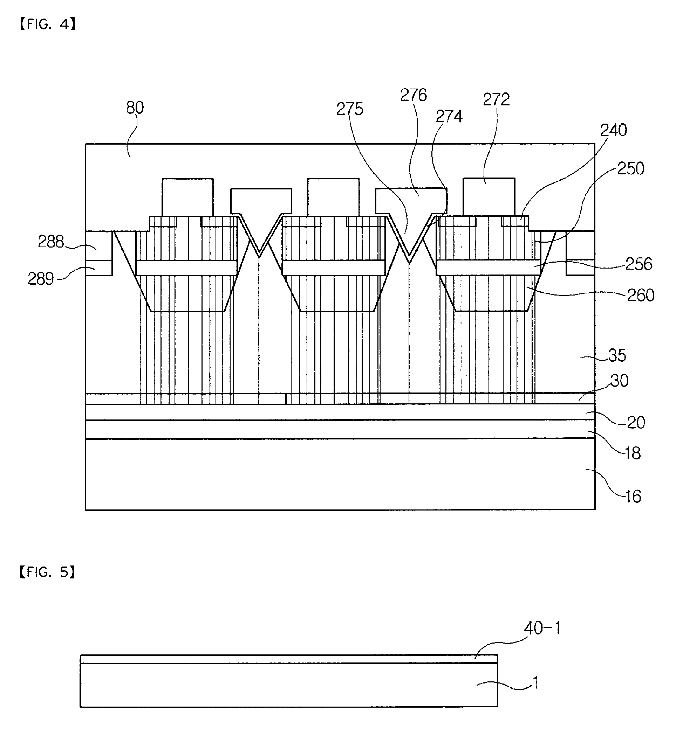

FIG. 4 illustrates a GaN-based FET capable of reducing the leakage current in accordance with another embodiment of the present invention.

Most of the elements of the illustrated GaN-based FET are similar to those of FIG. 1, but the GaN-based FET of FIG. 4 differs from that of FIG. 1 in that an additional switch semiconductor layer 256 is further included between a second switch semiconductor layer 250 and a third switch semiconductor layer 260. The additional switch semiconductor layer 256 may be made of GaN:C or GaN:Fe, and may effectively suppress the leakage current between the source electrode and the drain electrode that is attributable to counter electromotive force in the off state.

A gate core 275 of FIG. 4 may also be formed to be downward deeper compared to the case of FIG. 1 so that a forward pn junction potential can be sufficiently applied in the state in which the additional switch semiconductor layer 256 has been formed.

FIGS. 5 to 19B are process diagrams illustrating a process of fabricating the GaN-based FET of FIG. 1.

First, as illustrated in FIG. 5, an n+type GaN semiconductor layer 40-1 is formed on a sapphire substrate 1. The n+type GaN semiconductor layer 40-1 may be formed in thickness of less than 0.7 *µ*m.

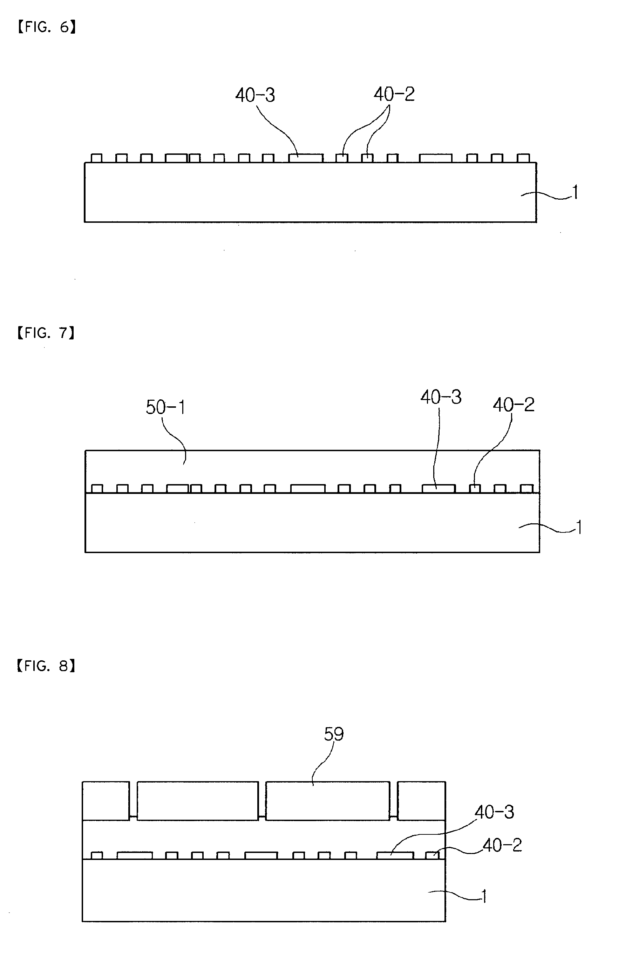

As illustrated in FIG. 6, n+type GaN semiconductor layers 40-3 to be placed under the gate electrodes and n+type GaN semiconductor layers 40-2 to be placed under the source electrodes are formed by etching the stacked n+type GaN semiconductor layer 40-1. In this case, dry etch or wet etch or both may be used as the etch method. For example, dry etch may be primarily performed, and etching using phosphoric acid, sulfuric acid, nitric acid, or hydrochloric acid may be then performed.

For example, the n+type GaN semiconductor layer 40-3 to be disposed under the gate electrode may have a width of 9 *µ*m, and the width between the n+type GaN semiconductor layer 40-2 to be disposed under the source electrode and an adjacent semiconductor layer may be 3 *µ*m.

As illustrated in FIG. 7, a p type GaN semiconductor layer 50-1 is formed by performing Epitaxial Lateral Overgrowth (ELO) using the n+type GaN semiconductor layers 40-3 to be disposed under the gate electrodes and the n+type GaN semiconductor layers 40-2 to be disposed under the source electrodes as a seed layer. For example, the p type GaN semiconductor layer 50-1 may be made of Mg impurities at an impurity concentration (i.e., an Mg concentration) of about 1.3×10¹⁷/cm³ to 5×10¹⁹/cm³. As illustrated in FIG. 7, the n+type GaN semiconductor layers 40-3 to be disposed under the gate electrodes and the n+type GaN semiconductor layers 40-2 to be disposed under the source electrodes have a lattice shape. The reason for this is that the degree of a distribution is widened as the seed layer for ELO.

As illustrated in FIG. 8, a photoresist 59 for gate isolation is coated on the p type GaN semiconductor layer 50-1. Thereafter, lithography is performed.

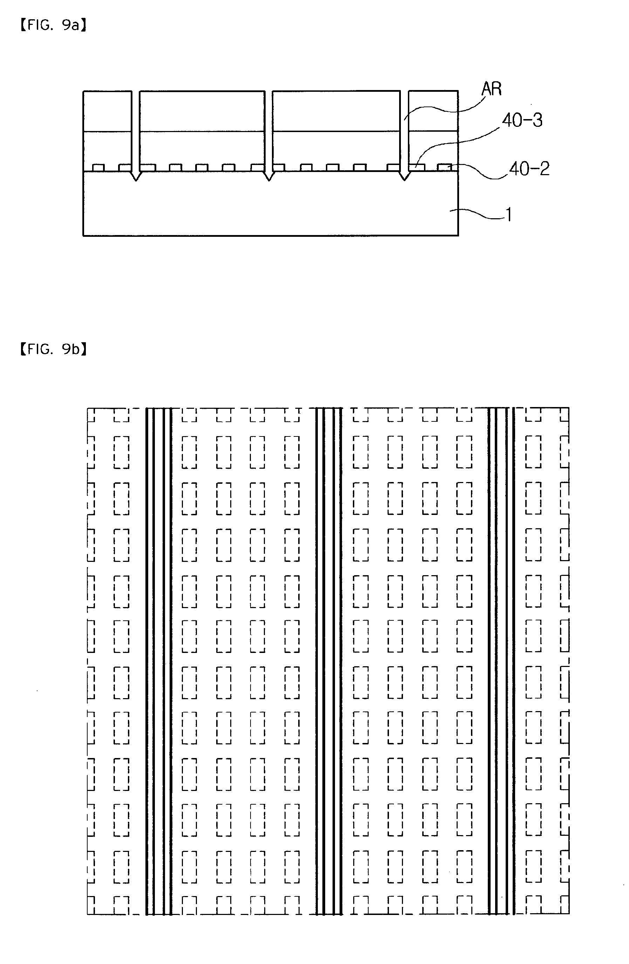

As illustrated in FIG. 9A, etching is performed on gaps (e.g., each gap may have a width of about 3 *µ*m) formed by the photolithography. The etching may be dry etch in the direction of an illustrated arrow AR. Accordingly, etching is performed up to the central areas of the n+type GaN semiconductor layers 40-3 to be disposed under the gate electrodes, and the sapphire substrate 1 under the n+type GaN semiconductor layers 40-3 is also partially etched. FIG. 9B is a plan view that is seen from the top of the stack structure of FIG. 9A. From FIG. 9B, it may be seen that regions etched in a straight line are formed along the central parts of the n+type GaN semiconductor layers to be disposed under the gate electrodes.

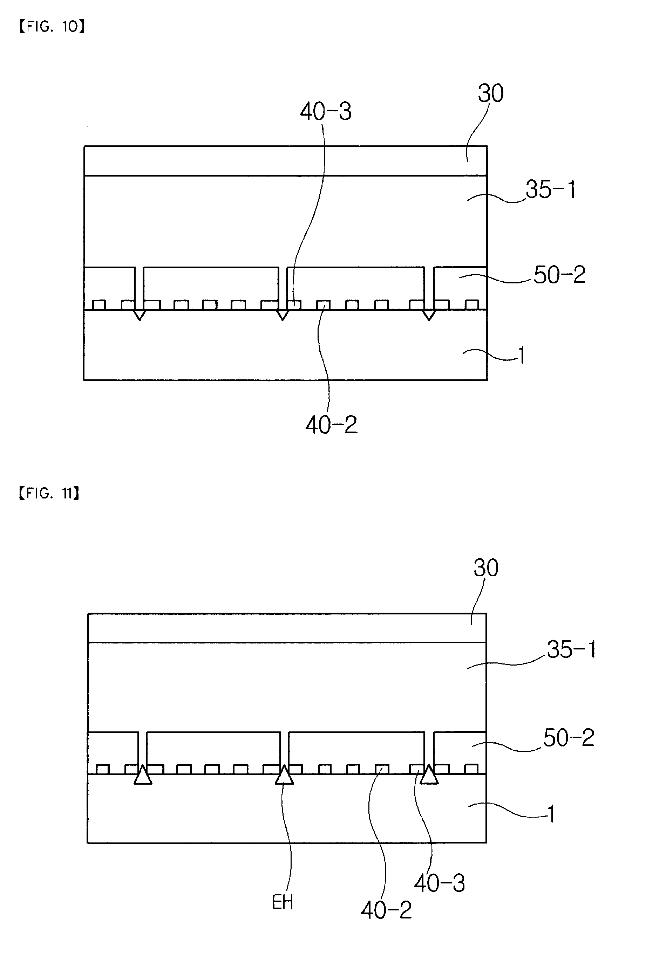

As illustrated in FIG. 10, the photoresist 59 is removed, and intrinsic GaN semiconductor layer 35-1 is stacked. The n+type GaN semiconductor layer 30 is stacked on the intrinsic GaN semiconductor layer 35-1. In the process of stacking the intrinsic GaN semiconductor layer 35-1, the gaps formed by the etch process of FIG. 9A are filled with the stacked intrinsic GaN semiconductor layer 35-1. In this case, the gaps formed in the n+type GaN semiconductor layers 40-3 to be disposed under the gate electrodes are filled, but the gaps formed in the sapphire substrate 1 having a different material characteristic are not filled.

Thereafter, as illustrated in FIG. 11, an etch process using a method of moving an etchant to the gaps maintained without changes in the structure of FIG. 10 through a capillary action may be performed. The etch process may be performed using relatively strong inorganic acid or inorganic base, such as phosphoric acid (H2PO4) or potassium hydroxide (KOH). In accordance with the etch process, the gaps present in the sapphire substrate 1 in the structure of FIG. 10 are extended, thereby removing part of the intrinsic GaN semiconductor layer 35-1 and the n+type GaN semiconductor layers 40-3 to be disposed under the gate electrodes.

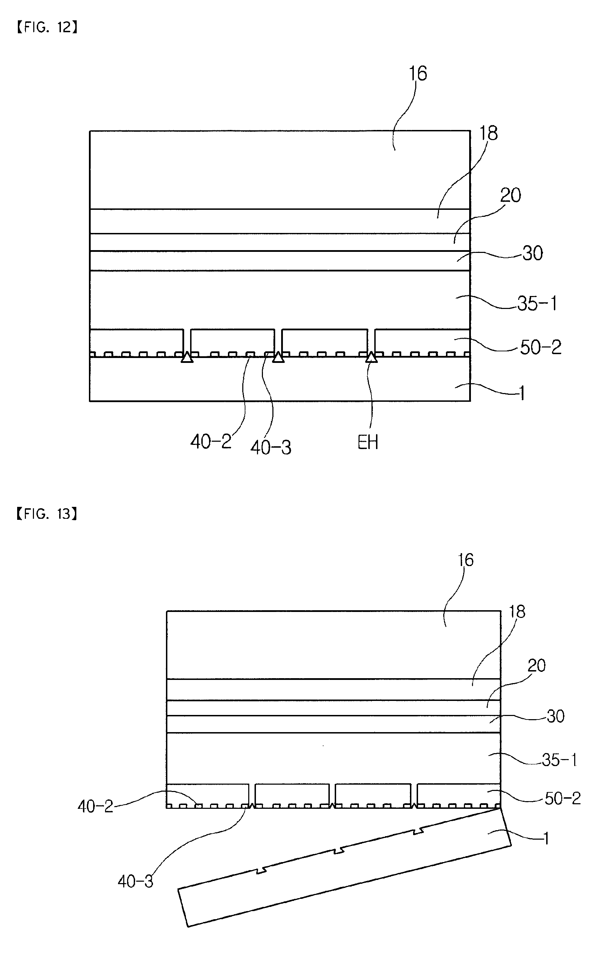

Thereafter, as illustrated in FIG. 12, the drain electrode 20 is stacked on the n+type GaN semiconductor layer 30. The medium layer 18 is stacked on the drain electrode 20, and the thermal conductive substrate 16 is attached to the medium layer 18.

The medium layer 18 may be made of novel metal-based materials having a high process affinity and thermal/electrical conductivity, such as nano Ag, AuSn, NiSn, Au, Ag, or Al. The thermal conductive substrate 16 may be a copper substrate made of materials that have excellent thermal conductivity and mechanical characteristics and that are suitable for process processing.

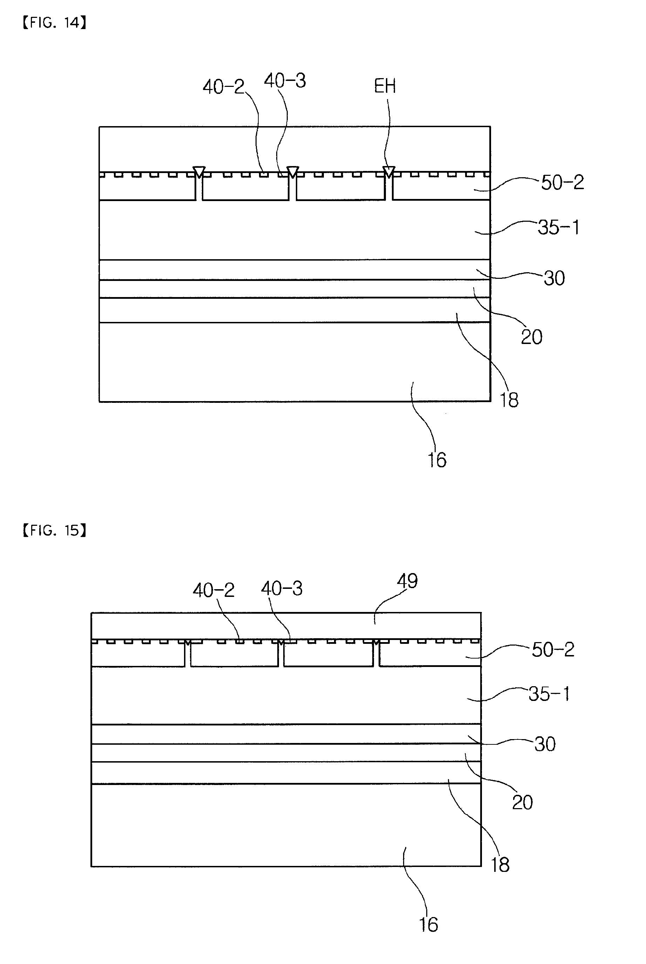

Thereafter, as illustrated in FIG. 13, the sapphire substrate is removed using a lift-off process. Dry etch may be performed in order to remove surfaces damaged by the lift-off process, as illustrated in FIG. 14. For example, the dry etch may be performed in a range of 0.15 ∼ 0.3 *µ*m.

Thereafter, as illustrated in FIG. 15, a photoresist 49 is formed in order to form a guard ring (not illustrated). The process of forming the guard ring is known to the art to which the present invention pertains, and a detailed description thereof is omitted.

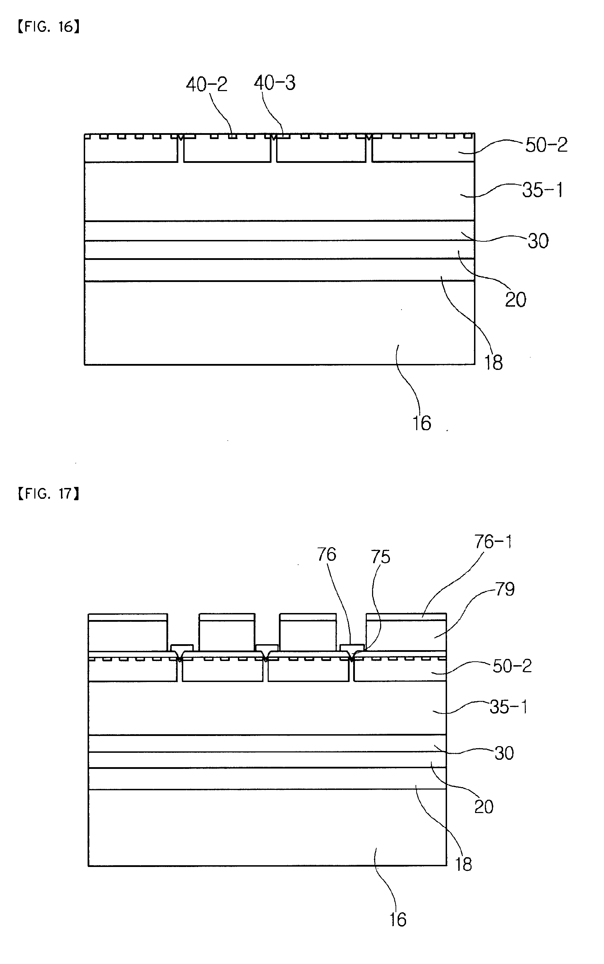

As illustrated in FIG. 16, the photoresist 49 is removed, and annealing is performed. For example, the annealing may be performed at a temperature of 600 °C for 20 minutes.

Thereafter, as illustrated in FIG. 17, an SiO₂ insulating layer 74 is formed on a top surface of the stack body of FIG. 16. A photoresist 79 is coated, regions of the photoresist 79 where the gate electrodes will be formed are removed by pholithograhy, and gate electrode layers 76 and 76-1 are formed. For example, the gate electrode layers 76 and 76-1 may be formed by depositing Ni/Au, but the present invention is not limited thereto. For example, the gate electrode layers 76 and 76-1 may be formed by various processes of depositing various conductive materials, such as metal and polysilicon. In accordance with the illustrated process,

The GaN-based FET of the present embodiment may include the gate insulating layer 74, that is, the SiO₂ insulating layer having V shapes, the gate cores 75 configured to fill the respective upper regions of the V shapes of the gate insulating layer 74, and the gate electrodes 76 disposed over the respective gate cores 75 and made of the same materials at the gate cores 75. Through the shapes of the gate cores 75, the FET of the present embodiment includes gates having inclined faces in which channels are formed.

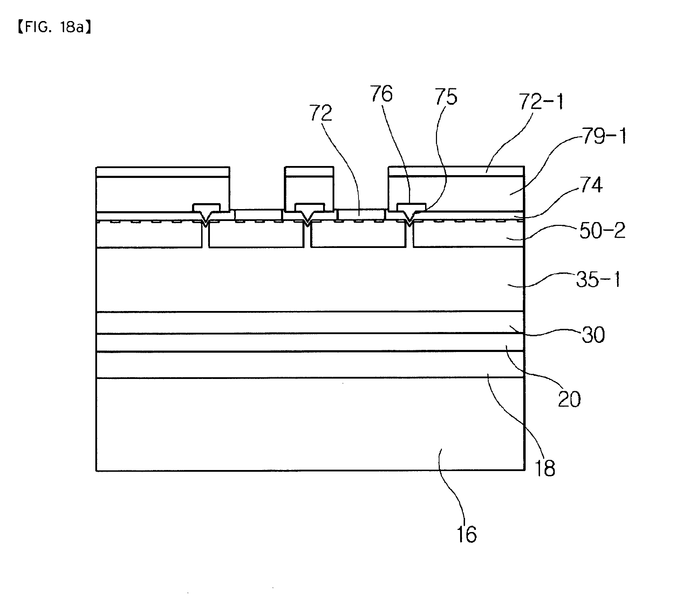

Thereafter, the remaining gate electrode layers 76-1 and the photoresists 79 are removed. As illustrated in FIG. 18A, a photoresist 79-1 is coated, regions of the photoresist where the source electrodes will be formed are removed by photolithography, and source electrode layers 72 and 72-1 are formed. For example, the source electrode layers 72 and 72-1 may be formed by depositing Ni/Au, but the present invention is not limited thereto. For example, the source electrode layers 72 and 72-1 may be formed by various processes of depositing various conductive materials, such as metal or polysilicon.

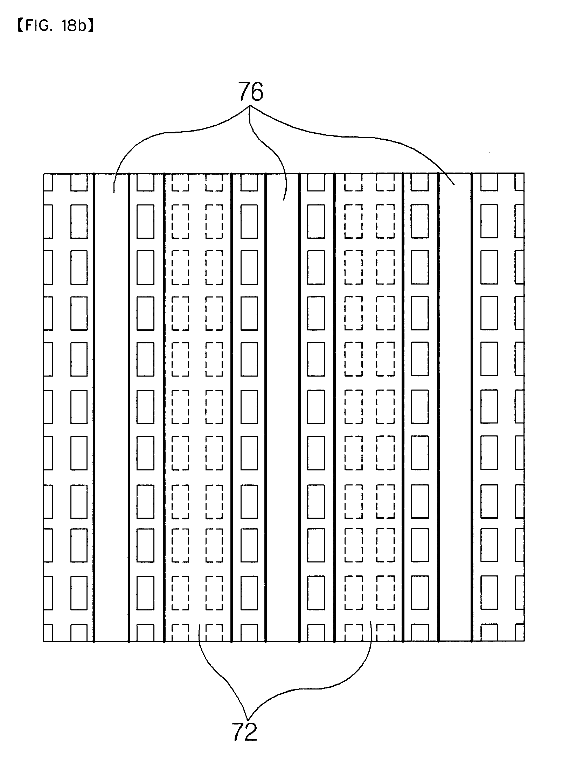

A plane seen from the top of the stack body from which the source electrode layers 72-1 and the photoresists 79-1 that remain after the processes of FIGS. 17 and 18A have been removed is illustrated in FIG. 18B. As illustrated in FIG. 18B, the three gate electrodes 76 and the three source electrodes 72 are formed in each transistor device. The number of each of the gate electrodes and the source electrodes in the plane diagram of FIG. 18B is different from that of FIG. 1, but this is a slight change to the extent that the number of each of the gate electrodes and the source electrodes illustrated in FIG. 18B is almost the same as that illustrated in FIG. 1.

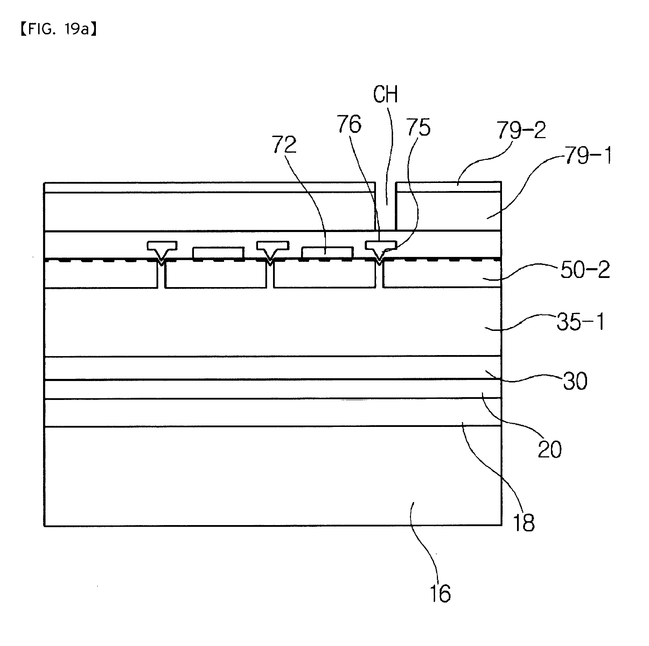

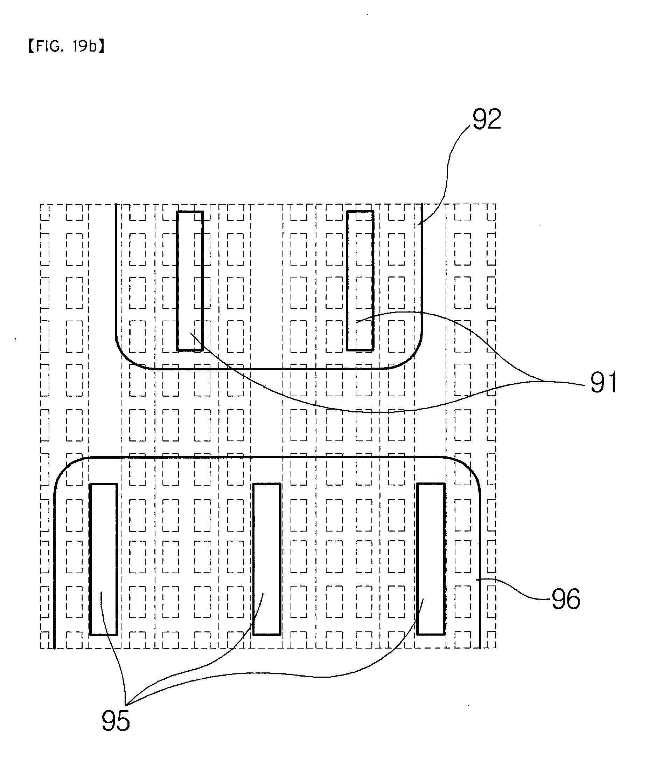

Thereafter, as illustrated in FIG. 19A, a photoresist 79-2 is coated, and contact holes CH are formed by photolithography. A plane in which contact pads for external drawing are formed is illustrated in FIG. 19B. The process of forming the contact holes CH and the contact pads are known to the art to which the present invention pertains, and a detailed description thereof is omitted.

Meanwhile, the illustrated processes do not include a process of forming the third switch semiconductor layers 60 made of intrinsic GaN (uGaN) in FIG. 1. The reason for this is that the third switch semiconductor layers 60 illustrated in FIG. 1 are not stack regions that are independently formed, but only regions that belong to the entire region of the intrinsic GaN semiconductor layer 35 and that function as n-p-n switch semiconductor layers along with the second switch semiconductor layer 50 and the first switch semiconductor layer 40 have been virtually classified for convenience of description.

In another implementation, the third switch semiconductor layers 60 may be independently made of n- GaN.

If the GaN-based FET according to an embodiment of the present invention is implemented, there is an advantage in that a high voltage resistant property, a high current density, and a normally off characteristic can be realized.

Furthermore, the present invention has an advantage in that a vertical type GaN-based FET having a normally off characteristic can be fabricated at low cost.

The embodiments of the present invention have been disclosed above for illustrative purposes. Those skilled in the art will appreciate that various modifications, additions and substitutions are possible, without departing from the scope and spirit of the invention as disclosed in the accompanying claims.

## Claims

1. A gallium nitride (GaN)-based transistor, comprising:
source electrodes;
first switch semiconductor layers of a first conductivity type formed under the respective source electrodes;
second switch semiconductor layers of a second conductivity type formed under the respective first switch semiconductor layers;
third switch semiconductor layers of the first conductivity type configured to surround lower parts of the second switch semiconductor layers and sides of the first switch semiconductor layers and the second switch semiconductor layers;
gates each having vertical faces or inclined faces in which a channel is formed on sides of the first switch semiconductor layer and the second switch semiconductor layer;
gate insulating layers formed under the gates; and
a drain electrode electrically coupled to the source electrodes along a flow of charges in a vertical direction that passes through the channels.

2. The GaN-based transistor of claim 1, wherein a depletion layer is formed in regions of the third switch semiconductor layers configured to surround the sides of the first switch semiconductor layers and the second switch semiconductor layers by the second switch semiconductor layers in a state in which voltage is not applied to the gate.

3. The GaN-based transistor of claim 1, further comprising an additional switch semiconductor layer made of GaN doped with carbon or iron and disposed between each of the second switch semiconductor layers and each of the third switch semiconductor layers.

4. The GaN-based transistor of claim 1, wherein an edge of part of the second switch semiconductor layer is configured to reach a boundary of the third switch semiconductor layer.

5. The GaN-based transistor of claim 1, wherein the first switch semiconductor layer is configured to have a seen layer capable of performing Epitaxial Lateral Overgrowth (ELO) on the second switch semiconductor layer.

6. The GaN-based transistor of claim 1, wherein:
an intrinsic GaN semiconductor layer and the drain electrode are disposed under the third transistor, and
the drain electrode is attached on top of a thermal conductive substrate.

7. A method of fabricating a GaN-based transistor, comprising:
forming a GaN semiconductor layer of a first conductivity type over a sapphire substrate;
forming switch semiconductor layers by etching the GaN semiconductor layer of the first conductivity type;
forming a GaN semiconductor layer of a second conductivity type by performing ELO using the GaN semiconductor layer of the first conductivity type as a seed layer;
etching regions which belong to the GaN semiconductor layer of the second conductivity type and the GaN semiconductor layer of the first conductivity type and in which gate electrodes are to be formed;
forming an intrinsic GaN semiconductor layer over the etched surfaces;
forming a high-concentration GaN semiconductor layer over the intrinsic GaN semiconductor layer;
extending etched spaces not filled with the intrinsic GaN semiconductor layer when forming the intrinsic GaN semiconductor layer over the etched surfaces;
forming a drain electrode over the high-concentration GaN semiconductor layer;
attaching a thermal conductive substrate to the drain electrode;
removing the sapphire substrate;
forming an insulating layer on a surface from which the sapphire substrate has been removed;
forming gate electrodes over the insulating layer;
etching regions of the insulating layer in which source electrodes are to be formed; and
forming the source electrodes.

8. The method of claim 7, wherein:
a lift-off process is used to remove the sapphire substrate, and
the method further comprises performing etching for removing surfaces damaged by the lift-off process before forming the insulating layer on the surface from which the sapphire substrate has been removed after removing the sapphire substrate.

9. The method of claim 7, further comprising forming a guard ring or performing annealing before forming the insulating layer on the surface from which the sapphire substrate has been removed after removing the sapphire substrate.

10. The method of claim 7, wherein extending the remaining etched spaces includes performing etching using a method of infiltrating an etchant into the spaces not filled with the intrinsic GaN semiconductor.

11. The method of claim 7, wherein attaching the thermal conductive substrate on top of the drain electrode comprises:
forming a medium layer over the drain electrodes; and
attaching the thermal conductive substrate on top of the medium layer.
